# EUROPEAN PATENT APPLICATION

(11) **EP 4 679 155 A1**
(43) Date of publication of application: **14.01.2026**
(21) Application number: 25188070.4
(22) Date of filing: 08.07.2025
(51) Int. Cl.: G02B 7/00, H05K 7/20

(54) **COOLING APPARATUS FOR OPTICAL MODULE**

(30) Priority: 09.07.2024 US 202463669045 P; 02.07.2025 US 202519258052
(71) Applicant: Google LLC, Mountain View, CA 94043 (US)
(72) Inventor: TILLEY, Evan, Mountain View, California, 94043 (US); JIN, Tiffany, Mountain View, California, 94043 (US); SIM, Henry K., Mountain View, California, 94043 (US); WANG, Yingying, Mountain View, California, 94043 (US)
(74) Representative: Betten & Resch

(57) **Abstract**

A cooling apparatus for an optical module includes a pedestal including a first pedestal surface and a second pedestal surface, wherein the first pedestal surface is attached to an outer surface of an optical module. A first boss and a second boss extends from opposing ends of the second pedestal surface, the first and the second boss define a first and a second opening having respective first and second through-apertures extending from the first and second openings through the pedestal to the first pedestal surface. A first manifold is attached to the first boss and configured to supply a liquid to the first through-aperture. A second manifold attached to the second boss and configured to receive the liquid from the second through-aperture.

## Description

### CROSS-REFERENCE TO RELATED APPLICATIONS

The present application claims priority to United States Provisional Patent Application No. 63/669,045, filed on July 9, 2024, the disclosure of which is incorporated herein by reference.

### BACKGROUND

Optical modules are often used in high density applications. Such high powered modules require increased cooling. Currently, cooling methods for optical modules include air cooling, riding heatsinks, and standalone cold plate systems.

### BRIEF SUMMARY

Aspects of this disclosure are directed to a cooling apparatus for an optical module having a full system cold plate loop using liquid cooling. Advanced high powered optics used in machine learning products and other high density applications require increased cooling. Liquid cooled cold plates improve the cooling efficiency of the optical module. In particular, some high powered optical modules require liquid cooling because air cooling is not adequate. The cooling apparatus of this disclosure includes multiple cooling pedestals or cooling contact points between the optical module and the cold plate. Each pedestal can move individually and apply up to 36 N of force on each optical module.

One aspect of the disclosure is directed to a cooling apparatus for an optical module comprising a pedestal configured to be attached to an outer surface of a cage housing an optical module, a gap pad attached to a first surface of the pedestal, a cold plate arranged on the gap pad, and a spring configured to secure the pedestal to the cage.

In some arrangements, the pedestal may comprise a bottom layer having a first thermal interface material.

In some arrangements, the plurality of pedestals may be attached to the gap pad.

In some arrangements, the gap pad may be made of a second thermal interface material.

In some examples, the gap pad is made of a flexible material configured to permit a movement of the pedestal relative to the cold plate.

Another aspect of the disclosure is directed to a cooling apparatus for an optical module comprising a base having a plurality of pedestals, a first heat pipe, a plurality of second heat pipes. Each pedestal of the plurality of pedestals is configured to move independently relative to other pedestals. Each of the second heat pipes is flexibly attached, at a first end, to an upper surface of each of the plurality of pedestals and is in thermal communication, at a second end, with the first heat pipe. Each of the plurality of second heat pipes is configured to flex with a movement of a corresponding pedestal of the plurality of pedestals.

In some arrangements, the base may be a cold plate.

In some arrangements, the cooling apparatus may comprise a plurality of compression springs. Each of the plurality of compression springs is configured to apply a predetermined force to the plurality of pedestals, and each compression spring corresponds to one of the plurality of pedestals.

In some examples, the second heat pipes are soldered or clamped with thermal grease with the first heat pipe.

Yet another aspect of the disclosure is directed to a cooling apparatus for an optical module comprising a chamber in a cold plate configured to be attached to an outer surface of a cage housing a plurality of optical modules and a plurality of pistons positioned within the chamber and attached to a corresponding pedestal of a plurality of pedestals. Each optical module of the plurality of optical modules is aligned with the corresponding pedestal. The chamber is configured to receive a flow of liquid and push each piston until a lower surface of each pedestal is flush with each optical module. Each of the plurality of pistons is configured to move dependent on a pressure of the liquid flowing through the chamber.

In some arrangements, the cooling apparatus may comprise an upper surface of the pedestal including fins.

Yet another aspect of disclosure is directed to a cooling apparatus for an optical module comprising a pedestal comprising a base component and a top component, and an opening. The base component is configured to be attached to a cage housing the optical module and having an inner surface. The top component remote from the base component, the top component secured to the base component using a spring. The opening is between the base component and the top component. A pipe extends through the opening and the pipe is in secured contact with the top component. The top component is configured to compress towards the base component until the inner surface of the base component is in thermal contact with the pipe. The pipe comprises a coolant flowing through the pipe.

In some arrangements, the pedestal may comprise a plurality of pedestals, each pedestal configured to move individually.

In some arrangements, the opening may include a thermal grease.

In some arrangements, the pipe is made of copper.

Yet another aspect of the disclosure is directed to a cooling apparatus for an optical module comprising a plurality of pedestals configured to be attached to an outer surface of a cage housing the optical module and a pipe extending from an inlet manifold to an outlet manifold. A section of the pipe is at least partially parallel to and in thermal contact with an upper surface of a corresponding pedestal of the plurality of pedestals.

In some arrangements, the pipe may be configured to extend from the inlet manifold and flex to contact more than one pedestal of the plurality of pedestals before engaging the outlet manifold.

Yet another aspect of the disclosure is directed to a cooling apparatus for an optical module comprising a pedestal comprising a first pedestal surface and a second pedestal surface. The first pedestal surface is configured to be attached to an outer surface of an optical module. A first boss and a second boss extend from opposing ends of the second pedestal surface. The first and the second bosses define first and second openings, respectively, and first and second through-apertures extend from the first and second openings, respectively, through the pedestal to the first pedestal surface. A first manifold is attached to the first boss and configured to supply a liquid to the first through-aperture. A second manifold is attached to the second boss and configured to receive the liquid from the second through-aperture.

In some arrangements, the first pedestal surface comprises one or more channels configured to direct flow of the liquid.

In some arrangements, the first and second manifolds comprise a cylindrical protrusion configured to receive the first and second boss, respectively.

In some arrangements, the first and second bosses are cylindrical.

In some arrangements, the cooling apparatus further comprises a sealing band arranged between the first and second bosses and an inner surface of the respective first and second manifolds and configured to prevent leakage of the liquid.

In some arrangements, the sealing band comprises a plurality of single rimmed o-ring seals.

In some arrangements, the sealing band comprises a double rimmed o-ring seal.

In some arrangements, the cooling apparatus further comprises one or more springs positioned between an upper surface of a platform above the pedestal and the second pedestal surface.

In some arrangements, one spring of the one or more springs is positioned between the first and second bosses.

In some arrangements, the pedestal is made of copper.

In some arrangements, the cooling apparatus further comprises a sealing band arranged around the first and second bosses between the second pedestal surface and an underside of the respective first and second manifolds and configured to prevent leakage of the liquid.

In some arrangements, the sealing band comprises a double rimmed o-ring seal.

In some arrangements, the first and second bosses include respective first and second grooves, the one or more sealing bands being positioned within the first and second grooves.

In some arrangements, the pedestal includes a plurality of pedestals.

In some arrangements, each pedestal of the plurality of pedestals is aligned with a corresponding optical module of a plurality of optical modules.

Yet another aspect of the disclosure is directed to a cooling system for an optical module comprising a plurality of pedestals configured to be attached to an outer surface of a plurality of optical modules, wherein each pedestal of the plurality of pedestals is configured to be aligned with a corresponding optical module of the plurality of optical modules. A first boss and a second boss extend from opposing ends of the pedestal. An inlet is connected to the first boss and configured to direct a liquid into the pedestal. An outlet is connected to the second boss and configured to direct the liquid out of the pedestal.

In some arrangements, the pedestal includes a first pedestal surface and a second pedestal surface, and the first pedestal surface comprises one or more channels.

In some arrangements, the first and the second bosses define first and second openings, respectively, and first and second through-apertures extending from the first and second openings, respectively, through the pedestal to the first pedestal surface.

In some arrangements, the cooling system further comprises one or more sealing bands arranged between the first and second bosses and an inner surface of the respective inlet and outlet configured to prevent leakage of the liquid.

In some arrangements, the first and second bosses each include a groove configured to receive a sealing band.

### BRIEF DESCRIPTION OF THE DRAWINGS

In the drawings, which are presented in simplified form and are not drawn to precise scale:
Fig. 1 is a front view of a cooling apparatus for an optical module according to aspects of the disclosure.
Fig. 2 is an enlarged side view of the cooling apparatus of Fig. 1.
Fig. 3 is a perspective top view of a cooling apparatus for an optical module according to aspects of the disclosure.
Fig. 4 is a perspective bottom view of the cooling apparatus of Fig. 2.
Fig. 5 is a perspective cross-sectional view of a cooling apparatus for an optical module according to aspects of the disclosure.
Figs. 6A-6B are perspective and cross-sectional perspective views, respectively, of a piston of the cooling apparatus of Fig. 5.
Fig. 7 is a perspective top view of the cooling apparatus of Fig. 5.
Fig. 8 is a perspective bottom view of the cooling apparatus of Fig. 5.
Fig. 9 is a perspective view of a cooling apparatus for an optical module according to aspects of the disclosure.
Figs. 10A-10B are enlarged front views of the cooling apparatus of Fig. 9.
Fig. 11 is a perspective view of a cooling apparatus for an optical module according to aspects of the disclosure.
Fig. 12 is a perspective top view of a cooling apparatus for an optical module according to aspects of the disclosure.

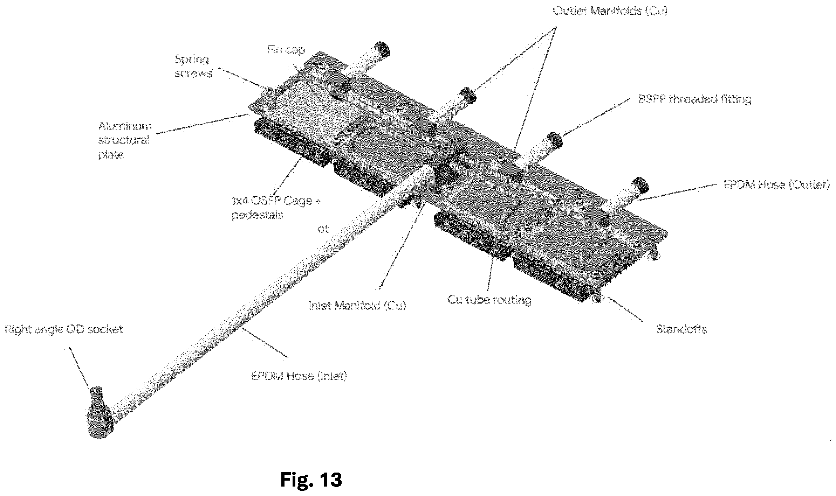

Fig. 13 is a perspective view of a cooling apparatus for an optical module according to aspects of the disclosure.

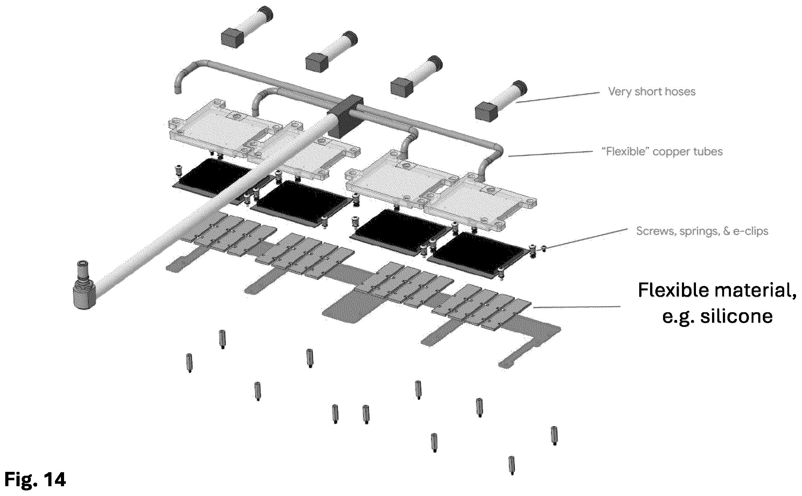

Fig. 14 is an exploded view of the cooling apparatus of Fig. 13.

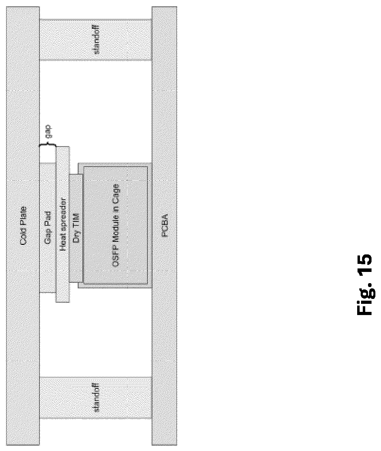

Fig. 15 is a schematic view of the cooling apparatus for an optical module according to aspects of the disclosure.
Fig. 16 is a perspective view of a cooling apparatus according to aspects of the disclosure.
Fig. 17 is a partial cross-sectional perspective view of the cooling apparatus of Fig. 16.

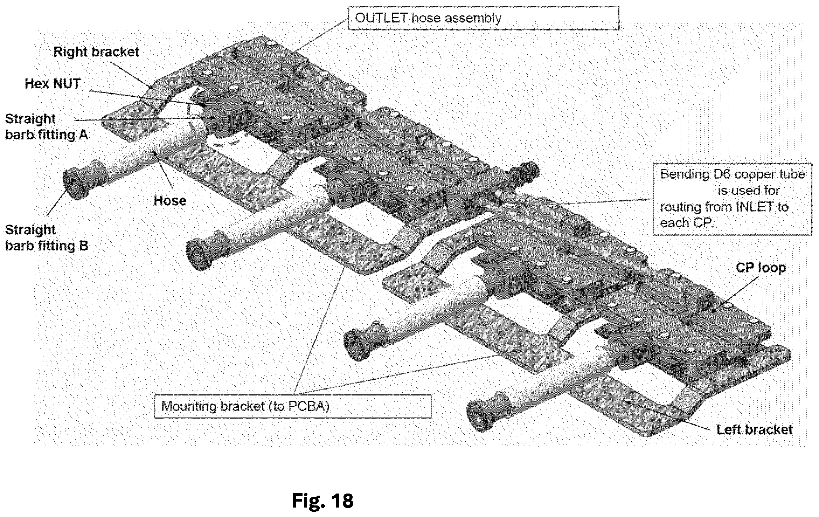

Fig. 18 is a perspective view of a cooling apparatus according to aspects of the disclosure.

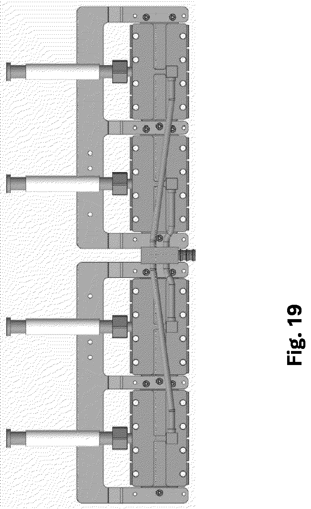

Fig. 19 is a top view of the cooling apparatus of Fig. 18.

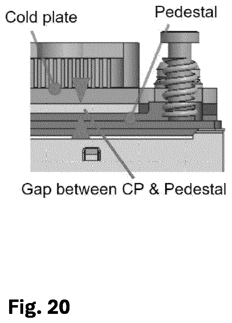

Fig. 20 is a partial cross-section view of the cooling apparatus of Fig. 18.

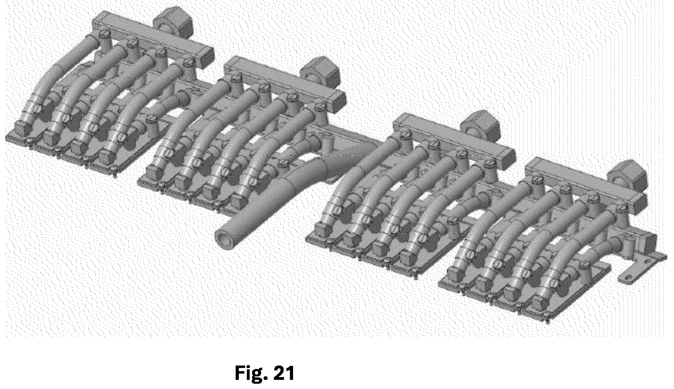

Fig. 21 is a perspective view of a cooling apparatus according to aspects of the disclosure.

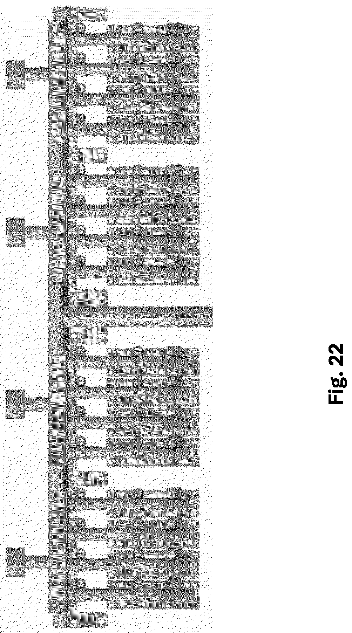

Fig. 22 is a top view of the cooling apparatus of Fig. 21.

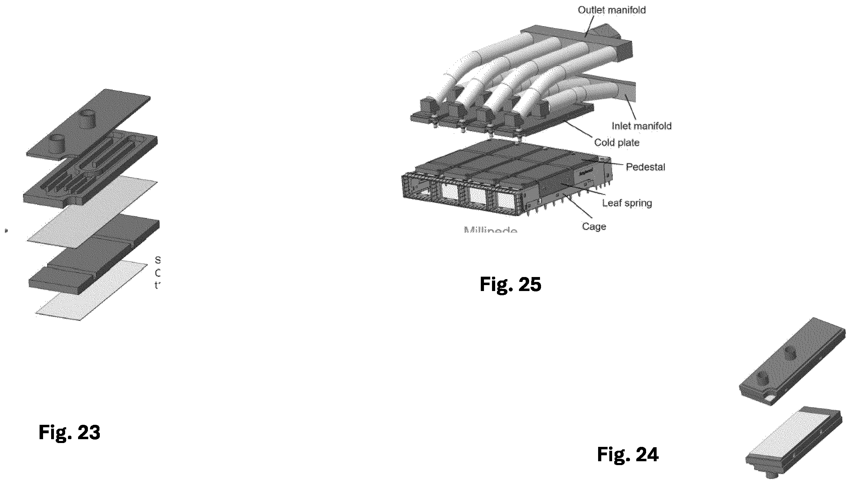

Figs. 23 and 24 are exploded views of a part of the cooling apparatus of Fig. 21.
Fig. 25 is a perspective view of the cooling apparatus of Fig. 21 along with a cage for the optical modules.

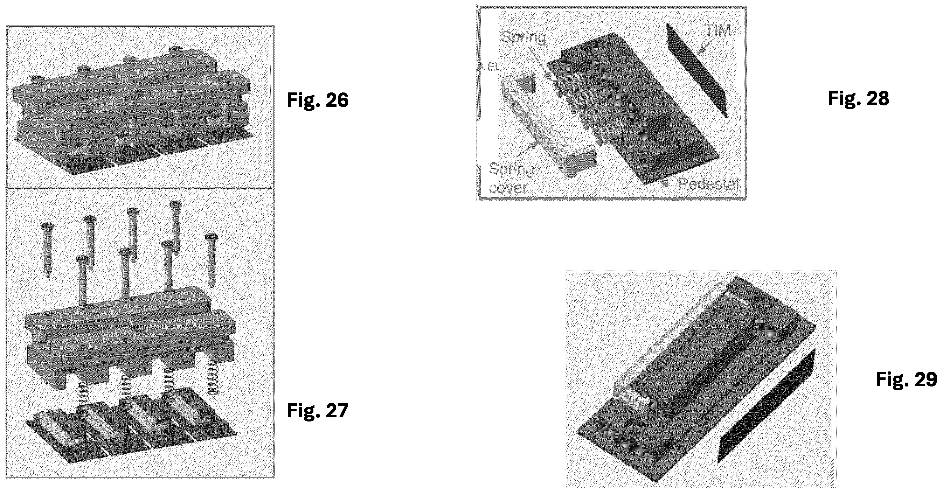

Fig. 26 is a perspective view of a cooling apparatus according to aspects of the disclosure.
Fig. 27 is an exploded view of the cooling apparatus of Fig. 26.
Fig. 28 is an exploded view of a cooling apparatus according to aspects of the disclosure.
Fig. 29 is a top view of the cooling apparatus of Fig. 28.

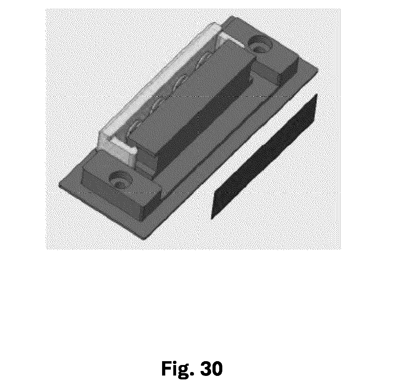

Fig. 30 is a perspective view of the cooling apparatus of Fig. 28.
Fig. 31 is a perspective cross-sectional view of a cooling apparatus for an optical module according to aspects of the disclosure.
Fig. 32 is a perspective view of a cooling apparatus for an optical module according to aspects of the disclosure.
Fig. 33 is a perspective cross-sectional view of the cooling apparatus of Fig. 32.
Fig. 34 is a perspective cross-sectional view of the cooling apparatus of Fig. 32.
Fig. 35 is a perspective view of a pedestal of the cooling apparatus of Fig. 32.
Fig. 36 is a perspective view of a sealing band of the cooling apparatus of Fig. 32.

### DETAILED DESCRIPTION

### Constant Gap Cooling Apparatus

Aspects of the disclosure relate to a cooling apparatus for an optical module including a pedestal configured to be attached to an outer surface of a cage housing an optical module and a gap pad attached to a first surface of the pedestal. A cold plate is arranged on the gap pad and a spring is configured to secure the pedestal to the cage. Each pedestal serves as a contact point between the cold plate and the cage housing the optical modules. Each pedestal can move individually. In some examples, the pedestal can apply up to 36N of force on each optical module. However, the optical module may be restricted in how much force it can withstand. As such, the cold plate of this disclosure uses the pedestals to regulate and manage the amount of force applied on the optical module when the cold plate is flush with the surface of the cage. Further, in some examples, the cold plate may be supported by a standoff to remove excess force on the optical modules due to the weight of the cold plate.

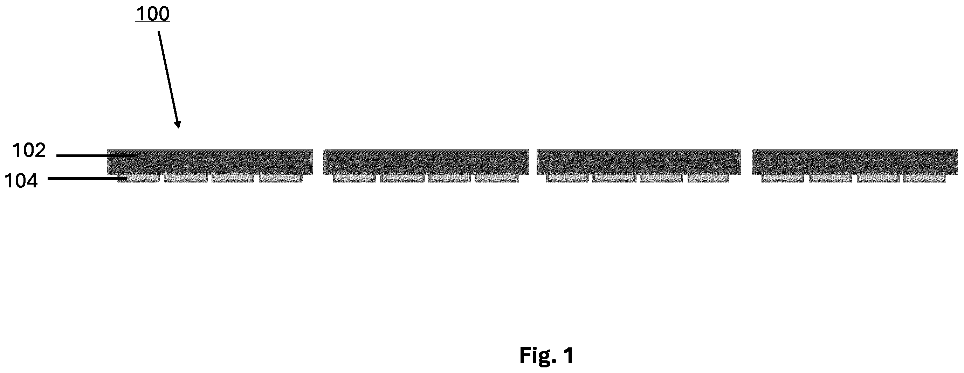

Fig. 1 is a front view of a cooling apparatus 100 for an optical module according to aspects of the disclosure. In some examples, the modules are housed within a cage in groups. In some examples, the modules may be grouped in four. An individual cold plate 102 may span across four pedestals 104.

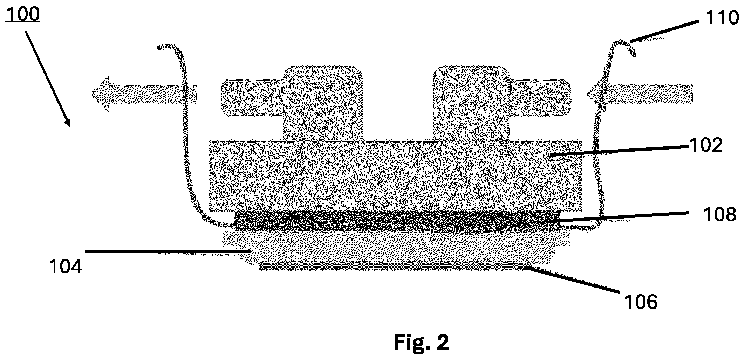

Fig. 2 is an enlarged side view of the cooling apparatus 100 of Fig. 1. As shown in Fig. 2, the pedestal 104 may be clipped to the cage (not shown). In some examples, the pedestal 104 may be attached to the cage using a spring 110 or a spring clip. The pedestal 104 includes a bottom layer 106 and the gap pad 108. The cold plate 102 is attached to the gap pad. Further, the bottom layer 106 may include a first thermal interface material. The gap pad 108 may be made of a second thermal interface material. In some examples, the cooling apparatus may include a constant gap pad thickness and double thermal interface layers. The gap pad 108 may include a soft thermal interface material which allows the pedestal to rise. In an example, the gap pad 108 is made of a flexible material configured to permit a movement of the pedestal relative to the cold plate 102. The gap pad 108 has similar properties to the first thermal interface material layer however, the second thermal interface material of the gap pad may be different from the first thermal interface material layer. The first thermal interface material of the bottom layer 106 may be made of a more durable thermal interface material. The second thermal interface material of the gap pad 108 may be soft and sponge-like as to absorb pressure.

In some examples, a cooling liquid or water may flow from one end of the cold plate and go out the other end. In other examples, a cooling liquid or water may be piped through or injected in the cold plate.

### Individual Pipe Cooling Apparatus

Aspects of the disclosure relate to a cooling apparatus for an optical module including a base having a plurality of pedestals and a first heat pipe and a plurality of second heat pipes. Each pedestal is configured to move independently relative to the other pedestals and each of the second heat pipes are flexibly attached at a first end to an upper surface of one of the plurality of pedestal and in thermal communication at a second end with the first heat pipe. Each of the second heat pipes is configured to flex with a movement of a corresponding pedestal.

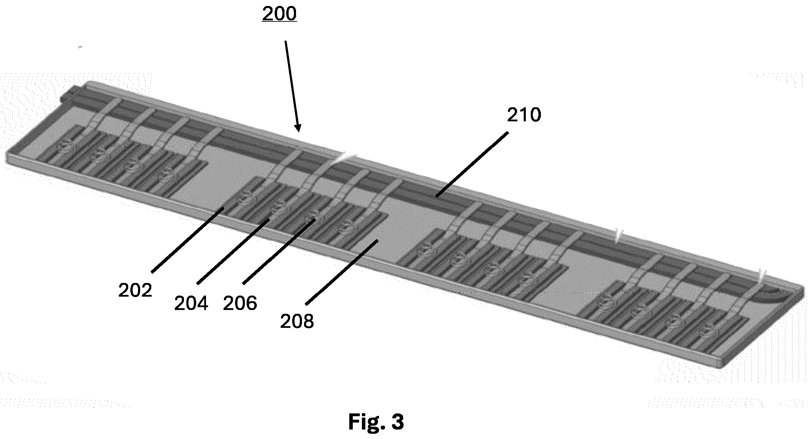

Fig. 3 is a perspective top view of a cooling apparatus 200 for an optical module according to aspects of the disclosure. As shown in Fig. 3, the base 208 may be a sheet like cold plate. The base 208 may be die cast or an aluminum-based sheet. Cooling liquid or water may flow through the base 208 through the first heat pipe 210. In some examples, the first heat pipe 210 may be a liquid heat exchanger. The liquid may flow from one end to the other end through the first heat pipe 210. A plurality of second heat pipes 204 extend transversely from the first heat pipe 210. Each of the second pipes 204 may be clamped or soldered in place corresponding to an individual pedestal 202. In some examples, the second heat pipes 204 may be soldered or clamped with thermal grease in between the first heat pipe 210 and the second heat pipe.

In some examples, the cooling apparatus includes a plurality of compression springs 206, wherein each of the compression springs applies a predetermined force to corresponding one of the plurality of pedestals 202. In some examples, a plurality of individual pedestals 202 are connected to the first heat pipe 210 using individual second heat pipes 204. The second heat pipes 204 may be thin enough to flex and to push downward on a surface of a cage housing a plurality of optical modules. In some examples, conical compression springs may apply force to each individual pedestal pushing it down on the cage of the module.

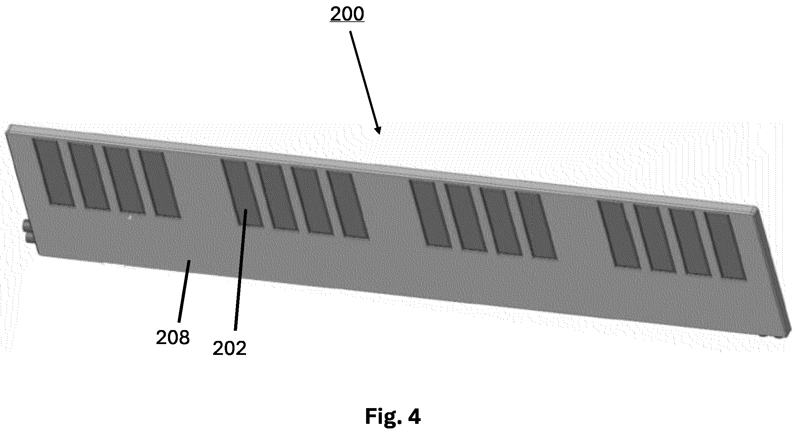

Fig. 4 is a perspective bottom view of the cooling apparatus 200 of Fig. 2. As shown in Fig. 4, the base 208 includes a plurality of pedestals 202. Each pedestal 202 has a bottom surface that when flexed downward is flush with the upper surface of the cage. The base 208 has openings for each pedestal 202 allowing each pedestal to individually flex downward and upward from the base. The pedestals 202 may be positioned in groups, for example groups of four as shown in Fig. 4.

### Individual Pistons Cooling Apparatus

Aspects of the disclosure relate to a cooling apparatus for an optical module including a chamber in a cold plate configured to be attached to an outer surface of a cage housing a plurality of optical modules. A plurality of pistons are positioned within the chamber and attached to a corresponding pedestal. Each optical module is aligned with the corresponding pedestal. The chamber is configured to receive a flow of liquid and push each piston until a lower surface of each pedestal is flush with each optical module.

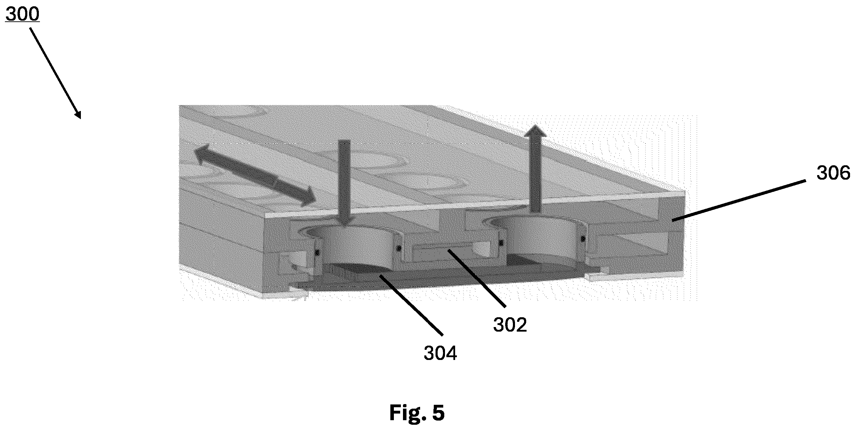

Fig. 5 is a perspective cross-sectional view of a cooling apparatus 300 for an optical module according to aspects of the disclosure. As shown in Fig. 5, the cooling apparatus includes a cold plate 306 having pistons 302 attached to a pedestal 304. The individual movement of the pedestals 304 is based on water pressure. In order to regulate the water pressure, an opening size, a number of openings, and a location of the openings may be varied across the cold plate. In some examples, hydraulic pressure may be maintained throughout the chamber of the cooling apparatus. A cooling liquid or water flows directly over the pistons 302 and applies a downward force on each piston which then pushes a lower surface of the pedestal 304 into contact with the cage housing the optical modules. As shown in Fig. 5, in some examples the piston 302 may be directly attached on top of a pedestal 304. The piston 302 may be configured to apply pressure on the pedestal 304 pushing it down into contact with an outer surface of the cage.

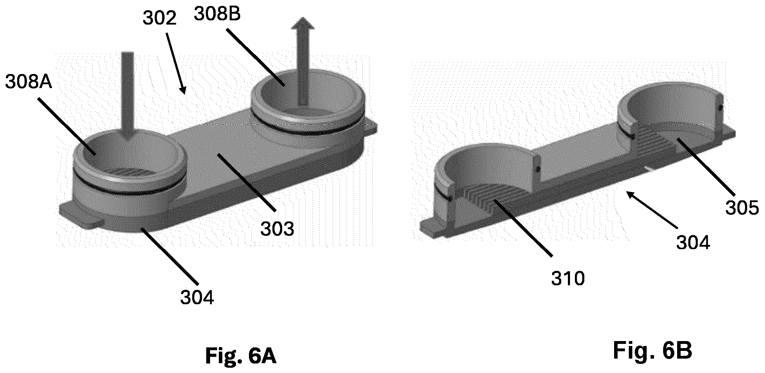

Figs. 6A-6B are perspective and cross-sectional perspective views, respectively, of a piston of the cooling apparatus of Fig. 5. As shown in Figs. 6A and 6B, the pistons 302 may include a pair of inlet and outlet o-ring orifices 308A, 308B. The pair of o-ring orifices 308A, 308B may extend upward from an upper surface 303 of the piston 302. In some examples, the o-ring pistons 308A, 308B may be positioned in at least partially parallel on the top of the pedestal 304.

As shown in Fig. 6B, in some examples, an entire upper surface 305 of the pedestal 304 may include fins 310. In other examples, one or more selected sections of the upper surface 305 of the pedestal 304 may include fins 310.

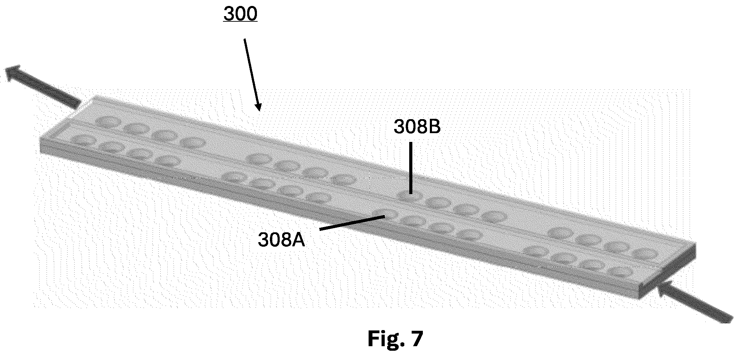

Fig. 7 is a perspective top view of the cooling apparatus 300 of Fig. 5. As shown in Fig. 7, the water may flow into the inlet o-ring orifice 308A and out of the outlet o-ring orifice 308B as the water moves from one end to the other end of the cold plate. In examples having fins, the water may flow through the fins. In some examples, the cold plate may include groups of pistons, for example four pistons arranged together along the cold plate.

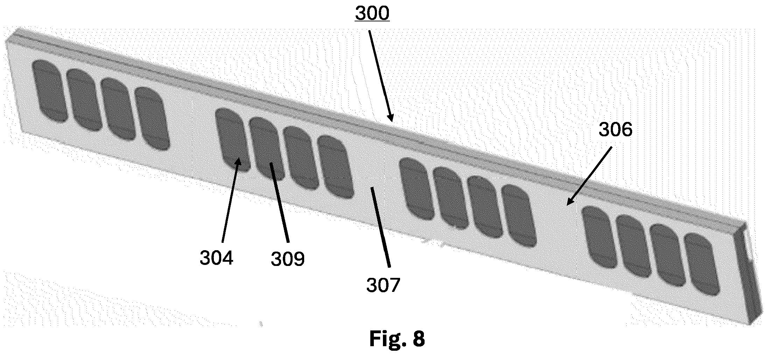

Fig. 8 is a perspective bottom view of the cooling apparatus 300 of Fig. 5. As shown in Fig. 8, the cold plate 306 includes a base 307 having a plurality of pedestals 304 under each piston. Each pedestal 304 has a bottom surface 309 that when flexed downward is flush with the upper surface of the cage. The base 307 has openings for each pedestal 304 allowing each pedestal to individually flex downward and upward from the base. The pedestals may be positioned in groups, for example groups of four as shown in Fig. 8.

### Keyboard Piston Cooling Apparatus

Aspects of the disclosure relate to a cooling apparatus for an optical module including a pedestal having a first pedestal surface and a second pedestal surface. The first pedestal surface is attached to an outer surface of an optical module. A first and a second boss extend from opposing ends of the second pedestal surface, defining first and second openings and respective first and second through-apertures that extend from the first and second openings to the first pedestal surface. The cooling apparatus further includes a first and second manifold, a first manifold is attached to the first boss and a second manifold is attached to the second boss. The first manifold supplies a liquid to the first through-aperture and the second manifold receives the liquid from the second through aperture.

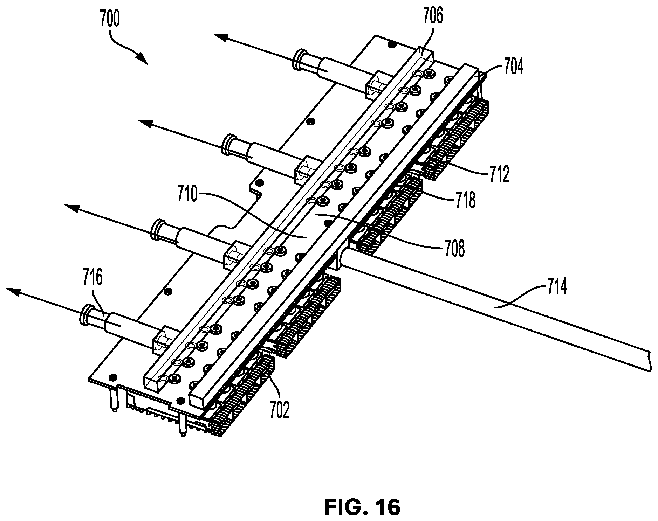

Fig. 16 is a perspective view of a cooling apparatus 700 for an optical module 702 according to aspects of the disclosure. As shown in Fig. 16, the cooling apparatus 700 may include a first manifold 704 and a second manifold 706 attached to an outer surface 708 of a platform 710 above a cage 712 encasing the optical module 702. In some examples, the platform 710 may be a plate that is propped up above the cage 712 using one or more standoffs to prevent the manifolds from applying pressure on the cage 712. In some examples, as shown in Fig. 16, the platform 710 may cover a plurality of cages 712, each cage encasing a plurality of optical modules 702. In some examples, each cage 712 may include four optical modules 702. Each cage 712 may have one or more openings on an upper surface of the cage such that an upper surface of each optical module within the cage is exposed. An inlet pipe 714 may be connected to the first manifold 704 for supplying coolant to the first manifold 704. In some examples, the inlet pipe 714 may connect to the first manifold 704 at a midpoint along a length of the platform 710. One or more outlet pipes 716 may be connected to the second manifold 706, extending outward from a length of the second manifold, for directing the coolant away from the second manifold. The first and second manifolds 704, 706 may direct a flow of a liquid supplied from the inlet pipe 714 through the cooling apparatus 700.

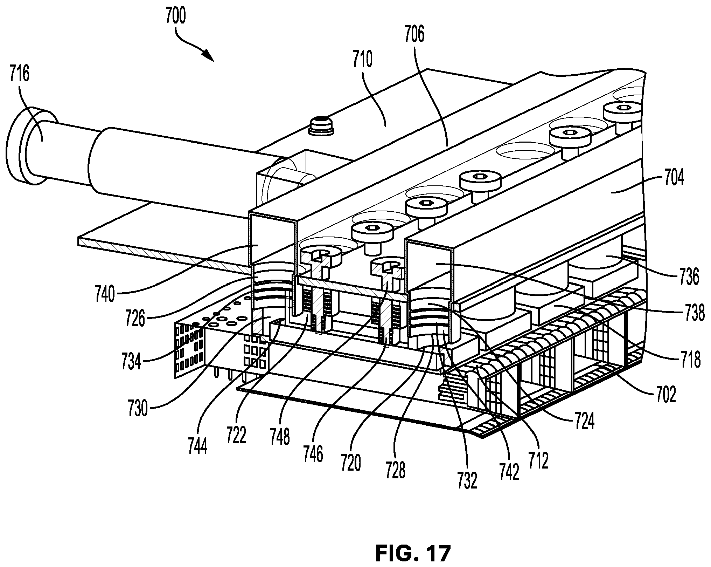

Fig. 17 is a perspective cross-sectional view of the cooling apparatus 700 of Fig. 16. As shown in Fig. 17, the cooling apparatus 700 includes a pedestal 718 stacked on top of an outer surface of the optical module 702. The pedestal 718 may extend through the opening of the cage 712. The cooling apparatus 700 may include a plurality of optical modules 702, each optical module 702 including a respective pedestal 718. As shown in Fig. 17, the platform 710 may be fixed to the pedestal 718 using one or more fasteners 748, for example, screws. In some examples, each fastener 748 may be fixed to a spring 746. The fasteners 728 may allow each pedestal 718 to accommodate a tolerance of movement due to forces applied upon the pedestal during insertion of the optical module 702 and from pressure exerted by the flow of liquid through the cooling apparatus 700. Additionally, the spring 746 may facilitate in balancing the force exerted on the pedestal 718.

Each pedestal 718 may include a first pedestal surface 720 and a second pedestal surface 722. The first pedestal surface 720 may abut the optical module 702. The second pedestal surface 722 may be adjacent to the platform 710 above the cage 712. The second pedestal surface 722 may be stacked on top of the first pedestal surface 720. The second pedestal surface 722 may include a first boss 724 and a second boss 726 extending upward from the second pedestal surface towards the platform 710. In some examples, the first and second bosses 724, 726 may be cylindrical. However, the shape and structure of the bosses are not limited as shown in the figures herein.

The first and second bosses 724, 726 each may define respective first and second through apertures 732, 734 with first and second openings 728, 730, respectively. Each of first and second through-apertures 732, 734 extend from the first and second openings 724, 726, respectively, through the pedestal 718 to the first pedestal surface 720. The first and second through-apertures 732, 734 may be cylindrical. However, the shape and size of the first and second through-apertures 732, 734 is not limited as shown in Fig. 17. In some examples, the first and second manifolds 704, 706 may include a cylindrical protrusion 736 extending from each manifold towards the pedestal 718. The cylindrical protrusion 736 may extend from the respective manifold through an opening in the platform 710 to contact the second pedestal surface 722. The first and second manifolds 704, 706 may define first and second recesses 738, 740, respectively, configured to receive a flow of coolant, the first and second recesses 738, 740 connecting to the corresponding cylindrical protrusions 736. In some examples, the first and second manifolds 704, 706 may each include a plurality of protrusions 736 extending towards the second pedestal surface 722. The protrusions 736 may be configured to receive or encase the first and second bosses 724, 726 on the second pedestal surface 722.

The first pedestal surface 720 may include one or more channels 744 which direct the flow of liquid through the cooling apparatus 700. For example, the liquid may flow from the inlet pipe 714 to the first manifold 704 into the cylindrical protrusion 736 and the first through-aperture 732. From the first through-aperture 732, the liquid may move through the channels 744 of the first pedestal surface 720 and out the second through-aperture 734 into the second manifold 706 and out the outlet pipe 716.

In some examples, the first pedestal surface 720 may be made of copper. In other examples, the first pedestal surface 720 may be made of any material having a high thermal conductivity. In some examples, the first and second manifolds 704, 706 may be made of stainless steel or any other material having high strength and wetted material compatibility. In some examples, the platform 710 may be made of steel or aluminum.

An interface between an inner surface of the cylindrical protrusions 736 and an outer surface of the first and second bosses 704, 706 of the pedestal 718 may be secured using a sealing band 742. In some examples, the cooling apparatus may include one or more sealing bands. In some examples, as shown in Fig. 17, the cooling apparatus may include three sealing bands. The sealing bands may be used to prevent leakage of the liquid flowing through the cooling apparatus. In some examples, the sealing band may include an o-ring seal. In some examples, the sealing band may include a double rimmed o-ring seal. In other examples, the sealing band may include a single rimmed o-ring seal.

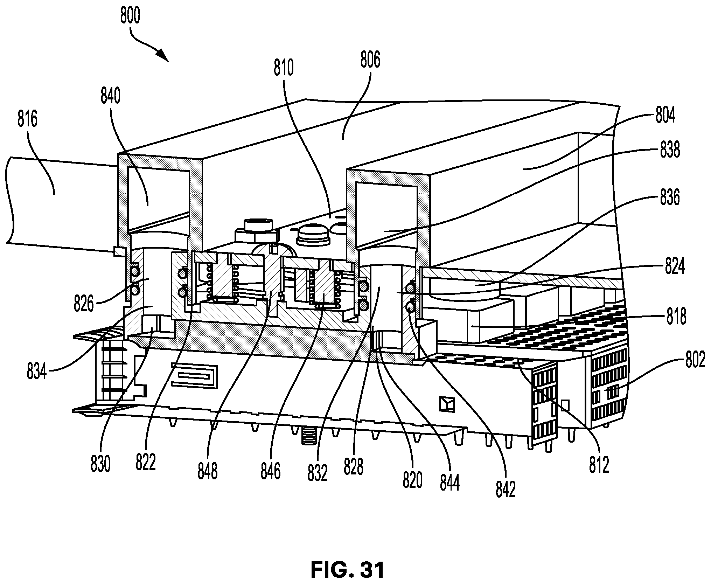

Fig. 31 is a perspective cross-sectional view of a cooling apparatus 800 for an optical module according to aspects of the disclosure. The cooling apparatus 800 of Fig. 31 is similar to that of cooling apparatus 700 of Figs. 16-17. However, as shown in Fig. 31, the cooling apparatus 800 may include two sealing bands 842. Further, cooling apparatus 800 may include a fastener 848 fixing the platform 810 to the pedestal 818. One or more springs 846 may be positioned between the platform 810 and the second pedestal surface 822. In some examples, a spring 846 may be positioned on either side of the fastener 848, between the first and second bosses 824, 826 on the second pedestal surface. The spring 846 and fastener 848 may function similarly to spring 746 and fastener 748 of cooling apparatus 700 as described above.

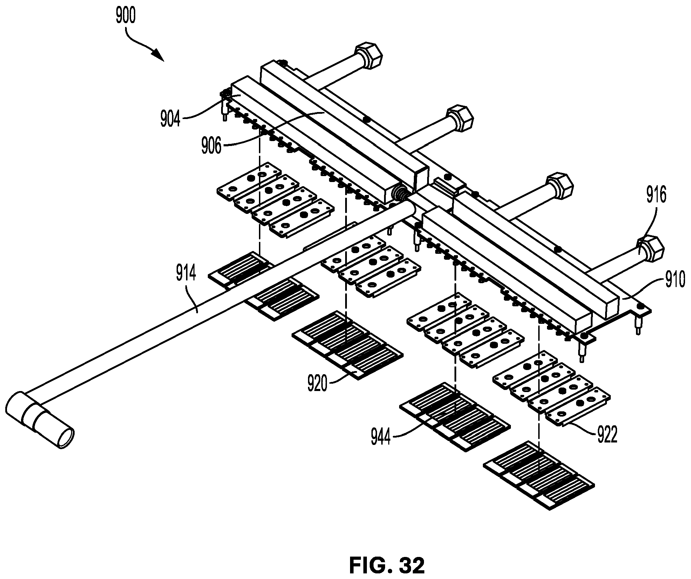

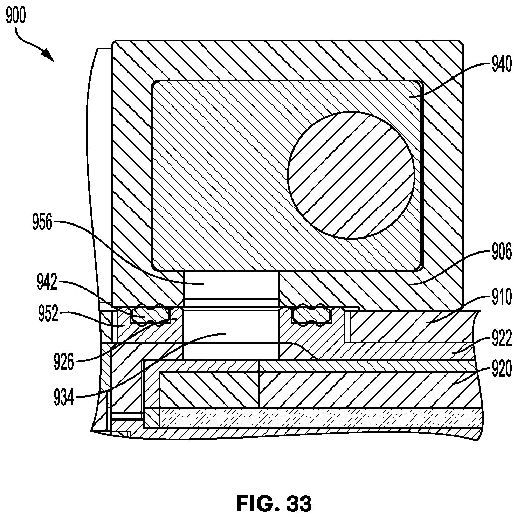

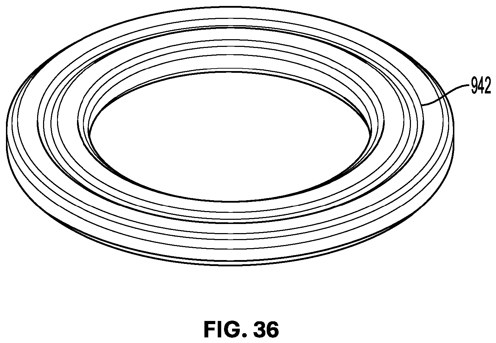

Fig. 32 is a perspective top view of a cooling apparatus 900 for an optical module according to aspects of the disclosure. The cooling apparatus 900 of Fig. 32 is similar to that of cooling apparatus 700, 800 of Figs. 16 and 31. However, as shown in Figs. 33 and 36, the second pedestal surface 922 may include the first and second bosses 924, 926 may include respective first and second grooves 950, 952.

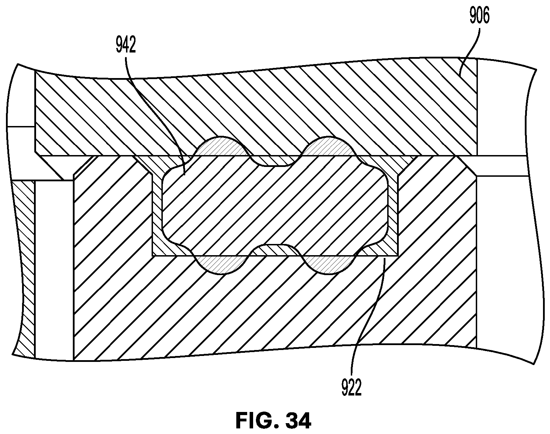

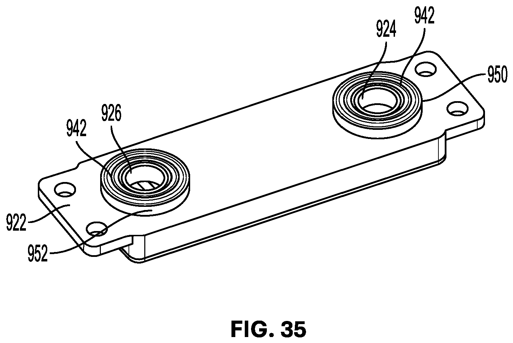

As shown in Fig. 33, each of the first and second manifolds 904, 906 may include corresponding through-apertures 956. The through-apertures 956 may be complementary to the through-apertures 932, 934 of the first and second bosses 924, 926. As shown in Fig. 34, a sealing band 942 is arranged between the second pedestal surface 922 and an underside of the respective first and second manifolds 904, 906 to prevent leakage of the liquid. As shown in Fig. 35, the sealing band 942 may be positioned within the first and second grooves 950, 952 of the respective first and second bosses 924, 926. As shown in Fig. 36, the sealing band 942 may be a double rimmed o-ring seal.

### Spring Loaded Pedestals Cooling Apparatus

Aspects of the disclosure relate to a cooling apparatus for an optical module including a pedestal comprising a base component and a top component. The base component is configured to be attached to a cage housing the optical module and having an inner surface. The top component is remote from the base component and the top component is secured to the base component using a spring. An opening between the base component and the top component has a pipe extending through the opening. The pipe is in secured contact with the top component. The top component compresses towards the base component until the inner surface of the base component is in thermal contact with the pipe.

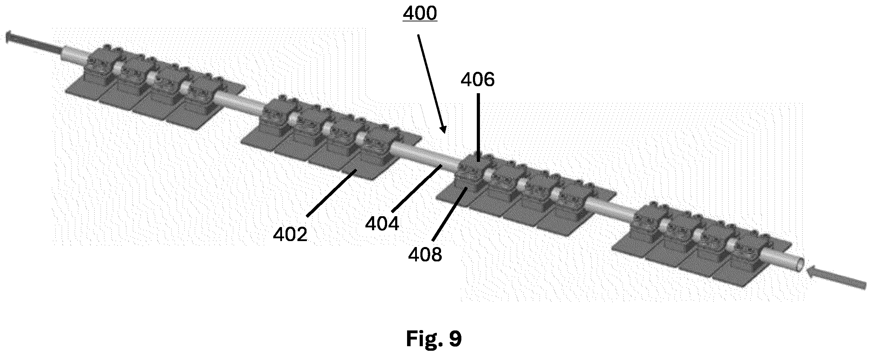

Fig. 9 is a perspective top view of a cooling apparatus 400 for an optical module according to aspects of the disclosure. As shown in Fig. 9, the pedestal 402 may include the plurality of pedestals 402 along the pipe 404. Each plurality of pedestals 402 may be separated into a group, for example four pedestals 402 may be positioned together along the same pipe 404. The base component 408 of the pedestal 402 is positioned underneath the pipe 404. The top component 406 is positioned over the curved surface of the pipe 404. Each pedestal 402 is configured to move individually with respect to the other pedestals.

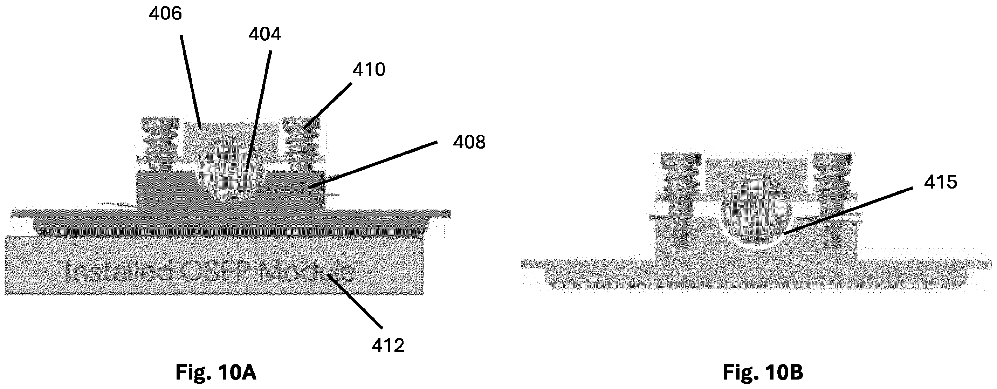

Figs. 10A-10B are enlarged front views of the cooling apparatus 400 of Fig. 9. As shown in Fig. 10A, the top component 406 includes an inner curved surface that is attached to an outer surface of the pipe 404. The top component 406 and the pipe 404 are held above the base component 408 using springs 410. In some examples, the spring 410 may be a cylindrical mechanical spring. In some examples, the spring clip of the riding heatsink cage can be used to secure the pedestals. The opening 415 extends underneath the pipe 404 before the base component 408 is moved upward into the pipe. As shown in Fig. 10A, when the module 412 is inserted into the cage the springs 410 are compressed upward and the opening 415 between the base component 408 and the pipe 404 is reduced. In some examples, the opening 415 may be filled with a thermal grease. The opening 415 may be in a cylindrical shape, but the shape is not limited as such. In some examples, the opening may be rectangular, square or polygonal. A thermal interface material may be layered on the bottom of the pedestal to enhance heat transfer from the cage holding the optical modules to the pedestal. In some examples, the pedestal may be made from copper or any other metal material.

The pipe 404 allows a coolant such as a cooling liquid or water to flow therethrough to absorb heat emitted by the plurality of pedestals. In some examples, the pipe may be made of copper. In some examples, the liquid flows through the pipe 0.8 GPM at 25 C at the time of entering an inlet of the pipe.

### Flexible Bellows Cooling Apparatus

Aspects of the disclosure relate to a cooling apparatus for an optical module including a plurality of pedestals configured to be attached to an outer surface of a cage housing the optical module and a pipe extending from an inlet manifold to an outlet manifold. A section of the pipe is at least partially parallel to and in thermal contact with an upper surface of a corresponding one of the plurality of pedestals.

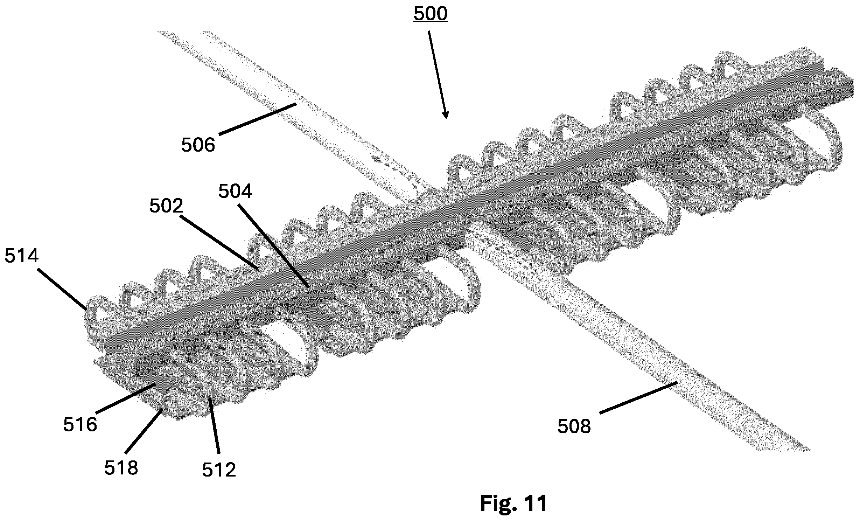

Fig. 11 is a perspective view of a cooling apparatus 500 for an optical module according to aspects of the disclosure. As shown in Fig. 11, the plurality of pedestals 518 may be positioned along an inlet manifold 504 and an outlet manifold 502 in groups, for example in groups of four. The inlet manifold 504 and the outlet manifold 502 extend over the plurality of pedestals 518. An inlet pipe 508 may extend transversely from the inlet manifold 504 and an outlet pipe 506 may extend transversely from the outlet manifold 502. The inlet pipe 508 supply cooling liquid or water through the inlet manifold 504 and into the pipe extending over each pedestal. The cooling liquid, after absorbing the heat from the optical modules, flows out the outlet manifold 502 creating a flow cycle. In some examples, the inlet and outlet manifolds 504, 502 may be positioned side by side at least partially in parallel.

In some examples, a section of the pipe 516 extending at least partially parallel to the pedestal 518 may be made of copper. The pipe may further include two flexible sections 512, 514, each extending from an end of the section of the pipe 516 at least partially parallel to the pedestal 518 to the inlet and outlet manifold 502, 504, respectively. In particular, a first flexible section extends 512 from the inlet manifold 504 to the pedestal 518 and a second flexible section 514 extends from the pedestal to outlet manifold 502. In some examples, the flexible sections 512, 514 may be stainless steel bellows having a diameter around 3 mm. In other examples, the flexible sections 512, 514 may compress vertically about 1 mm. In some examples, the pedestal may be made of copper. In some examples, the pedestals may have microchannels.

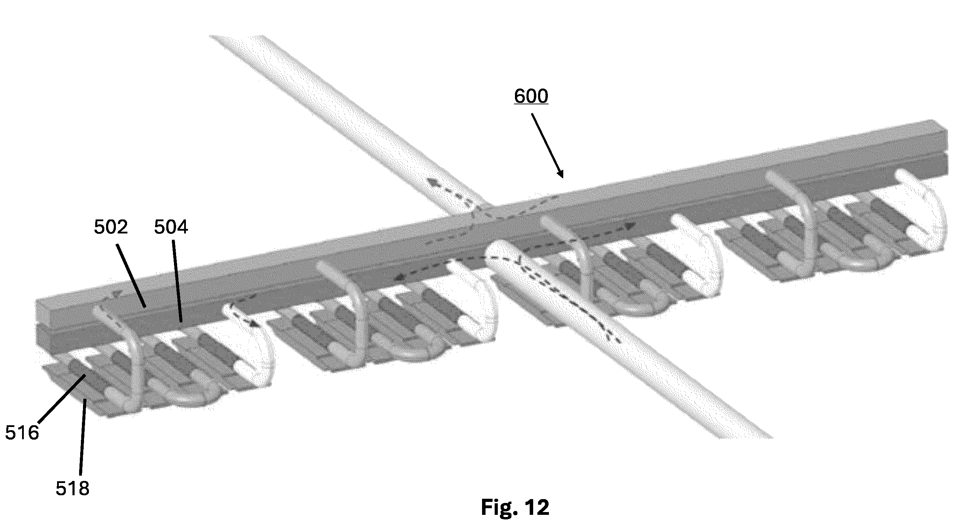

Fig. 12 is a perspective top view of a cooling apparatus 600 for an optical module according to aspects of the disclosure. The cooling apparatus 600 of Fig. 12 is similar to that of cooling apparatus 500 of Fig. 11. Except that, as shown in Fig. 12, in some examples, the pipe is configured to extend from the inlet manifold 504 and flex to contact more than one pedestal 518 of the plurality of pedestals before engaging the outlet manifold 502. The flexible pipe goes from inlet manifold 504 to a plurality of pedestal 518 and then to the outlet manifold 502. The flexible portions may be made of a metal. In other examples, the flexible portions may be made of an ethylene propylene diene monomer. As shown in Fig. 12, the pipe is configured to extend from the inlet manifold 504 and flex to contact a group of pedestals 518 before returning the flow cycle to the outlet manifold 502. The section of the pipe 516 is at least partially parallel to the pedestal 518 and a plurality of pedestals share an inlet and outlet connection. In some examples, the inlet and outlet manifold may be stacked vertically directly on top of each other.

Although the implementations disclosed herein have been described with reference to particular features, it is to be understood that these features are merely illustrative of the principles and applications of the present implementations. It is therefore to be understood that numerous modifications, including changes in the sizes of the various features described herein, may be made to the illustrative implementations and that other arrangements may be devised without departing from the spirit and scope of the present implementations. In this regard, the present implementations encompass numerous additional features in addition to those specific features set forth in the paragraphs above.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. In addition, the provision of the examples described herein, as well as clauses phrased as "such as," "including" and the like, should not be interpreted as limiting the subject matter of the claims to the specific examples; rather, the examples are intended to illustrate only one of many examples. Further, the same reference numbers in different drawings can identify the same or similar elements.

## Claims

1. A cooling apparatus for an optical module, comprising:
a pedestal comprising a first pedestal surface and a second pedestal surface, wherein the first pedestal surface is configured to be attached to an outer surface of an optical module;
a first boss and a second boss extending from opposing ends of the second pedestal surface, wherein the first and the second bosses define first and second openings, respectively, and first and second through-apertures extending from the first and second openings, respectively, through the pedestal to the first pedestal surface;
a first manifold attached to the first boss and configured to supply a liquid to the first through-aperture; and
a second manifold attached to the second boss and configured to receive the liquid from the second through-aperture.

2. The cooling apparatus of claim 1, wherein the first pedestal surface comprises one or more channels configured to direct flow of the liquid; and/or
wherein the first and second manifolds comprise a cylindrical protrusion configured to receive the first and second boss, respectively; and/or
wherein the first and second bosses are cylindrical.

3. The cooling apparatus of claim 1 or 2, further comprising a sealing band arranged between the first and second bosses and an inner surface of the respective first and second manifolds and configured to prevent leakage of the liquid.

4. The cooling apparatus of claim 3, wherein the sealing band comprises a plurality of single rimmed o-ring seals; or
wherein the sealing band comprises a double rimmed o-ring seal.

5. The cooling apparatus of any one of claims 1 to 4, further comprising one or more springs positioned between an upper surface of a platform above the pedestal and the second pedestal surface.

6. The cooling apparatus of claim 5, wherein one spring of the one or more springs is positioned between the first and second bosses.

7. The cooling apparatus of any one of claims 1 to 6, wherein the pedestal is made of copper.

8. The cooling apparatus of any one of claims 1 to 7, further comprising a sealing band arranged around the first and second bosses between the second pedestal surface and an underside of the respective first and second manifolds and configured to prevent leakage of the liquid.

9. The cooling apparatus of claim 8, wherein the sealing band comprises a double rimmed o-ring seal; and/or
wherein the first and second bosses include respective first and second grooves, the one or more sealing bands being positioned within the first and second grooves.

10. The cooling apparatus of any one of claims 1 to 9, wherein the pedestal includes a plurality of pedestals.

11. The cooling apparatus of claim 10, wherein each pedestal of the plurality of pedestals is aligned with a corresponding optical module of a plurality of optical modules.

12. A cooling system for an optical module, comprising:
a plurality of pedestals configured to be attached to an outer surface of a plurality of optical modules, wherein each pedestal of the plurality of pedestals is configured to be aligned with a corresponding optical module of the plurality of optical modules;
a first boss and a second boss extending from opposing ends of the pedestal;
an inlet connected to the first boss and configured to direct a liquid into the pedestal; and
an outlet connected to the second boss and configured to direct the liquid out of the pedestal.

13. The cooling system of claim 12, wherein the pedestal includes a first pedestal surface and a second pedestal surface, and the first pedestal surface comprises one or more channels.

14. The cooling system of claim 13, wherein the first and the second bosses define first and second openings, respectively, and first and second through-apertures extending from the first and second openings, respectively, through the pedestal to the first pedestal surface.

15. The cooling system of any one of claims 12 to 14, further comprising one or more sealing bands arranged between the first and second bosses and an inner surface of the respective inlet and outlet configured to prevent leakage of the liquid; and
wherein optionally the first and second bosses each include a groove configured to receive a sealing band.
